Europäisches Patentamt

European Patent Office

Office européen des brevets

(11) Veröffentlichungsnummer: 0 250 722
A2

## (12) EUROPÄISCHE PATENTANMELDUNG

(21) Anmeldenummer: 87104508.4

(22) Anmeldetag: 26.03.87

(51) Int. Cl.4: H01L 21/82

(30) Priorität: 04.07.86 DE 3622504

(43) Veröffentlichungstag der Anmeldung:
07.01.88 Patentblatt 88/01

(84) Benannte Vertragsstaaten:
AT DE FR GB IT NL SE

(71) Anmelder: Siemens Aktiengesellschaft Berlin
und München
Wittelsbacherplatz 2
D-8000 München 2(DE)

(72) Erfinder: Neppl, Franz, Dr.
St. Quirin-Platz 6
D-8000 München 90(DE)
Erfinder: Mazuré-Espejo, Carlos-Alberto, Dr.
Heinrich-Egger-Strasse 10
D-8011 Kirchseeon(DE)

(54) Verfahren zur Herstellung benachbarter, mit Dotierstoffionen unterschiedlichen Leitungstyps implantierter Wannen für hochintegrierte CMOS-Bauelemente.

(57) Bei einem Verfahren zur Herstellung benachbarter, mit Dotierstoffionen unterschiedlichen Leitungstyps implantierter Wannen (9, 11) in mit einer Epitaxieschicht (2) versehenen Siliziumsubstrate (1) wird in die zur Maskierung für die n-Wannenbereiche (11) bei der Implantation der p-Wannen (9) vorgesehene Siliziumnitridschicht (4) gezielt eine laterale Unterätzung (7) mit hoher Selektivität zu den darunterliegenden Schichten (1, 2, 3) eingebracht, so daß sich bei der nachfolgenden Oxidation die Kante der als Maskierung dienenden Siliziumoxidschicht (8, 17, 18) in Richtung n-Wannen (11) verschiebt. Durch diese Art der selbstjustierten Wannenerzeugung (9, 11) wird der Einfluß der Gegendotierung im Bereich der Wannengrenzen deutlich verringert. Zusätzlich kann als Maskierschicht (3, 4) auch unter der Siliziumnitridschicht (4) eine Polysiliiumschicht (16) verwendet werden, die nach der Unterätzung (7) der Siliziumnitridschicht (4) mitaufoxidiert wird und auf diese Weise anstelle des vogelschnabelähnlichen Verlaufs (17) einen kastenförmigen Verlauf (18) des Maskieroxids (8) erzeugt, wodurch eine steilere Diffusionsfront bei der n-Wanne (11) erreicht wird. Das Verfahren dient der Herstellung hochintegrierter komplementärer MOS-Feldeffekttransistorschaltungen.

FIG 7

FIG 9

## Verfahren zur Herstellung benachbarter, mit Dotierstoffionen unterschiedlichen Leitungstyps implantierter Wannen für hochintegrierte CMOS-Bauelemente.

Die Erfindung betrifft ein Verfahren zur Herstellung benachbarter, mit Dotierstoffionen unterschiedlichen Leitungstyps implantierter Wannen bei der Herstellung von hochintegrierten komplementären MOS-Feldeffekttransistoren (CMOS-Schaltungen), bei dem als Halbleitersubstrat $n^+$- bzw. $p^+$-dotiertes Silizium mit einer darauf befindlichen $n^-$-bzw. $p^-$-dotierten Epitaxieschicht verwendet wird, in die zuerst die p-Wannen unter Verwendung einer mit Photolack bedeckten Siliziumoxid-Siliziumnitrid-Schicht als Maskierungsschicht für die n-Wannenbereiche und dann die n-Wannen unter Verwendung einer mit Photolack bedeckten Siliziumoxidschicht als Maskierungsschicht für die p-Wannenbereiche eingebracht werden und bei dem durch gezieltes laterales Unterätzen der für die Erzeugung der p-Wannen dienenden Maskierschicht und nachfolgender Oxidation vor dem Erzeugen der n-Wannen die Kante der als Maskierung dienenden Siliziumoxidschicht in Richtung n-Wannenbereiche verschoben wird.

Ein solches Verfahren ist aus der europäischen Patentanmeldung 0 081 804 bekannt.

Moderne CMOS-Prozesse sind Doppel-Wannen-Prozesse (n-und p-Wannen) und werden im IEEE Trans. on Electron. Devices, ED-30 (1983) auf den Seiten 1339 bis 1344 und im IEDM Technical Digest 1984, 15.4, auf den Seiten 410 bis 413 ausführlich beschrieben. Die Herstellung der beiden Wannen geschieht unter Verwendung von getrennten Masken oder durch einen selbstjustierenden Prozeßablauf unter Verwendung nur einer Maske.

Der Nachteil des selbstjustierten Doppelwannenprozesses ist die Entstehung eines kompensierten Bereiches an den Wannenkanten wegen der räumlichen Überlappung bei der Wannendotierung. Deren Größe und Kompensationsgrad haben direkten Einfluß auf die Latch-up-Anfälligkeit der CMOS-Struktur bzw. auf den minimal möglichen $n^+/p^+$-Abstand. Dieser Effekt begrenzt die Eindringtiefe $x_j$ der Wanne auf relativ kleine Werte. Dies führt wegen der hohen Stromdichten bzw. des höheren oberflächennahen Stromanteils zu einer erhöhten Empfindlichkeit des Wannen-MOSFET's gegenüber Substratströmen (Öffnen der Source-Diode). Außerdem sind die Junction-Kapazitäten vergleichsweise hoch, da die Gesamtladung in der Wanne durch Anforderungen an die Durchbruchsspannung $U_{CEO}$ und die Grundzahl des parasitären Bipolartransistors vorgegeben ist und daher bei flachen Wannen die Dotierungskonzentration hoch ist.

Die Aufgabe, die der Erfindung zugrundeliegt, besteht in der Durchführung eines CMOS-Wannenprozesses, bei dem gewährleistet ist, daß eine starke räumliche Überlappung und ladungsmäßige Kompensation an der Implantationskante der beiden n-bzw. p-implantierten Wannengebiete vermieden wird, ohne daß die Transistor-Performance verschlechtert wird.

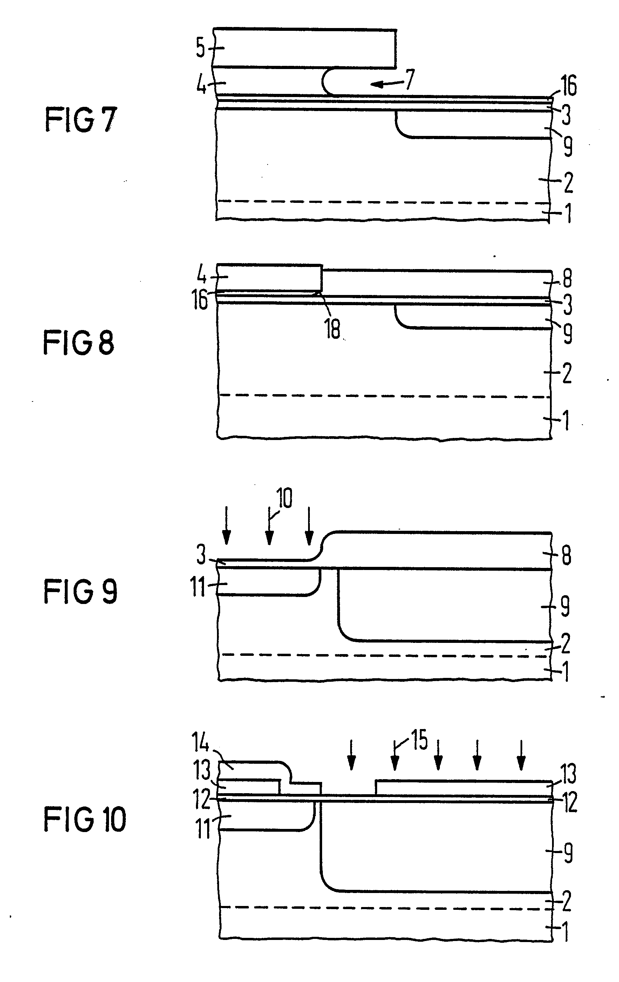

Bei dem eingangs genannten Verfahren aus der europäischen Patentanmeldung 0 081 804 wird dies dadurch erreicht, daß die p-Wanne vor der n-Wanne implantiert wird, die n-Wanne eine wesentlich geringere Eindringtiefe als die p-Wanne aufweist und beim Ablösen der Oxidschicht eine starke Unterätzung des Oxids unter die Nitridmaske angestrebt wird, so daß beim nachfolgenden Erzeugen des Maskieroxids für die p-Wanne ein möglichst langer vogelschnabelähnlicher Auslauf (bird's beak) des Maskieroxids gebildet wird, welcher die nachfolgende Phosphorionenimplantation maskiert. Die Implantation der n-Wanne ist dann um den Abstand der unterätzten (ins Oxid geätzten) Nitridschicht von der Implantationskante der p-Wanne getrennt (1 bis 2 $\mu$m, siehe Figur 8 der europäischen Patentanmeldung).

Die Erfindung löst die gestellte Aufgabe auf eine andere Weise und erzielt damit eine weitere Verbesserung in bezug auf die Unterdrückung der Gegendotierung im Bereich der Wannengrenzen. Sie ist dadurch gekennzeichnet, daß die Unterätzung mittels eines isotropen Ätzprozesses so geführt wird, daß sie in die unter der Photolackmaske liegende Siliziumnitridmaskenschicht erfolgt und dabei die darunterliegenden Schichten nicht merklich angeätzt werden.

Durch die Erzeugung der starken lateralen Unterätzung vor der Photolackentfernung in die Nitridmaske hinein mittels eines isotropen Ätzgemisches mit hoher Selektivität zu den darunterliegenden Schichten wird die Kante der nachfolgenden lokalen Maskieroxidation um die Unterätzung verschoben, so daß die Trennung der beiden Wannenimplantationskanten jetzt durch Vogelschnabellänge und Unterätzung gegeben ist. Es tritt zwar gegenüber der in der europäischen Patentanmeldung 0 081 804 beschriebenen Anordnung kein verlängerter Vogelschnabel auf, aber es wird eine, zusätzlich um die Unterätzungslänge vergrößerte Oxidmaske gleicher Dicke gebildet. Dies ermöglicht die Anpassung der räumlichen Trennung der n-und p-Wannen-Implantationen an die Eindiffusion der p-Wanne und somit eine starke Unterdrückung bzw. Vermeidung des lateralen Kompensationseffektes. Der bedeutende Vorteil dieses Vorgehens gegenüber den bekannten Verfahren ist die Entkopplung der Wannen-Eindringtiefe von der lateralen Gegendotierung. Es ermöglicht die Erzeugung tieferer Wannen bei gleichbleibender Implantationsdosis ohne Zunahme der Latch-up-Empfindlichkeit, wodurch die Transistor-Performance positiv beeinflußt wird. Bei nicht ausreichender Widerstandsfähigkeit des Photolacks gegenüber der langen Überziehung der Si₃N₄-Ätzung zur Erzielung der erfindungsgemäßen Si₃N₄-Unterätzung kann eine Polysilizium-Hilfsschicht direkt auf dem Nitrid verwendet werden, die zunächst mit der Photolackmaske strukturiert wird und bei der starken Überziehung der isotropen Si₃N₄-Ätzung die Nitridoberfläche auch dann - schützt, wenn zuviel Photolack abgetragen wird.

In einer Weiterbildung des Erfindungsgedankens ist vorgesehen, anstelle der Siliziumoxid-Siliziumnitrid-Doppelmaskenschicht eine Dreifachschicht, bestehend aus Siliziumoxid, Polysilizium und Siliziumnitrid zu verwenden und die Polysiliziumschicht zur Maskierung der p-Wannenbereiche mitaufzuoxidieren. Da die Aufoxidation von der Polysiliziumschicht ausgeht die direkt vom Siliziumnitrid bedeckt ist, wird die Bildung eines Vogelschnabels weitgehend unterdrückt und ein kastenförmiges Maskieroxid erzeugt. Dadurch wird eine Verschmierung der Implantationskante infolge der im Vogelschnabelbereich abnehmenden Maskieroxiddicke vermieden und eine steilere Diffusionsfront bei der n-Wannen-Eintreibung erreicht, die sich günstig auf das latch-up-Verhalten auswirkt.

Weitere Ausgestaltungen der Erfindung ergeben sich aus den Unteransprüchen.

Im folgenden soll anhand von zwei Ausführungsbeispielen und der Figuren 1 bis 10 die Erfindung noch näher erläutert werden. Dabei zeigen

die Figuren 1 bis 5 den Prozeßablauf mit einer aus Siliziumoxid und Siliziumnitrid bestehenden Doppelmaskierschicht und

die Figuren 5 bis 10 den Prozeßablauf mit einer Dreifachmaskierschicht bestehend aus Siliziumoxid, Polysilizium und Siliziumnitrid.

In allen Figuren gelten für gleiche Teile gleiche Bezugszeichen.

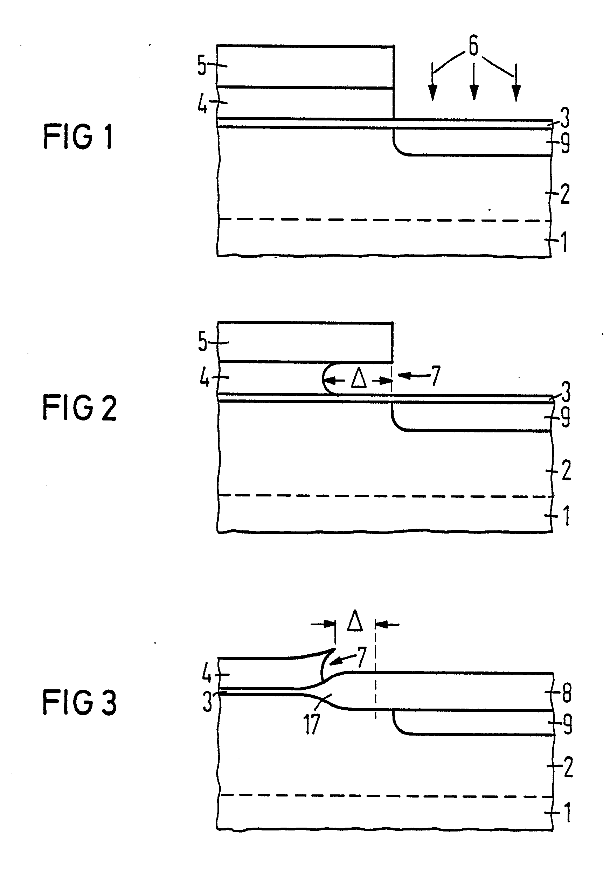

Figur 1: Zu Beginn der Prozeßfolge wird die p-Wanne 9 hergestellt. Dabei wird von einem, mit einer n⁻-dotierten Epitaxieschicht 2 ((100)-Si, 20 Ohm cm, 6 bis 8 μm) versehenen n⁺-dotierten Siliziumsubstrat 1 ((100)-Si, 0,020 Ohm cm) ausgegangen, welches mit einer Oxidschicht 3 (50 nm) und mit einer, mit einer Photolackmaske 5 strukturierten Siliziumnitridschicht 4 von 100 nm Dicke versehen ist. Die Bor-Ionen-Implantation 6 erfolgt mit einer Dosis und Energie von $2 \times 10^{12}$ cm⁻² und 160 keV.

Figur 2: Nun erfolgt der erste erfindungswesentliche Schritt der gezielten Unterätzung Δ (siehe Pfeil 7) in die Siliziumnitridschicht 4 hinein, wobei eine Phosphorsäurelösung (H₃PO₄) von 85 % und 160°C verwendet wird und sich bei einem Ätzverhältnis Nitrid/Oxid von 40:1 bei einer Ätzdauer von 250 - 300 min eine laterale Ätztiefe von 1 μm ergibt.

Figur 3: Im Anschluß an die laterale Unterätzung 7 wird die Photolackmaske 5 entfernt und das Maskieroxid 8 für den p-Wannenbereich 9 für die nachfolgende Phosphor-Ionen-Implantation (10) zur Erzeugung der n-Wanne (11) in einer Schichtdicke von 0,5 - 1,0 μm erzeugt. Das Maskieroxid 8 entsteht im Bereich der Unterätzung Δ (7) nur zum Teil mit einem vogelschnabelähnlichen Kantenverlauf 17.

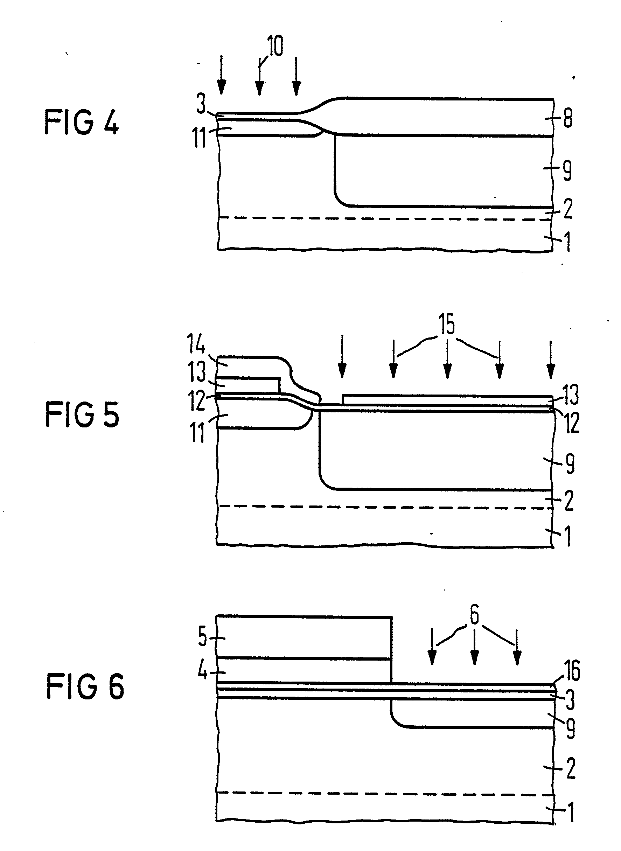

Figur 4: Die Siliziumnitridschichtstruktur 4 wird entfernt und nach Temperung und drive-in der p-Wanne 9 bei zum Beispiel 1150°C in 100 bis 600 Minuten je nach Dicke der Epitaxieschicht 2 die Phosphor-Ionen-Implantation 10 zur Erzeugung der n-Wanne 11 mit einer Dosis und Energie von $1 \times 10^{12}$ cm⁻² und 180 keV durchgeführt.

Figur 5: Mittels einer Temperung bei 1000°C, zwei bis drei Stunden, werden beide Wannen 9 und 11 eingetrieben. Die gesamte Oxidschicht 3, 8 wird entfernt und die Maskierschichten 12, 13, bestehend aus Siliziumoxid 12 und Siliziumnitrid 13 für den nachfolgenden LOCOS-Prozeß aufgebracht und durch Photolithographie (nicht abgebildet) strukturiert. Nach dem Abdecken der Gebiete außerhalb der p-Wanne 9 mit einer Photolackmaske 14 wird die Feld-Ionen-Implantation der Gebiete der n-Kanal-Feldoxidtransistoren mittels einer Bor-Ionen-Implantation 15 mit einer Dosis und Energie von $1 \times 10^{13}$ cm⁻² und 25 keV durchgeführt.

Ab diesem Prozeßschritt folgt der Prozeß einer konventionellen Technologie, wobei abhängig von Gateoxiddicke und Gatematerial eine oder mehrere Kanal-Ionen-Implantationen nach entsprechenden Phototechniken durchzuführen sind. Die Prozeßführung ist im wesentlichen bekannt. Sie folgt zum Beispiel dem in der europäischen Patentanmeldung 0 0135 163 beschriebenen Prozeßverlauf.

Figur 6: Auch hier wird, wie bei Figur 1 bereits beschrieben, von einem, mit einer n⁻-dotierten Epitaxieschicht 2 versehenen n⁺-dotierten Siliziumsubstrat 1 ausgegangen. Dieses Substrat 1, 2 wird nun mit einer Dreifachschicht der Schichtenfolge Siliziumoxid 2 (50 nm dick), Polysilizium 16 (100 - 200 nm dick) und Siliziumnitrid 4 (100 - 200 nm dick) belegt und die oberste, aus Siliziumnitrid bestehende Schicht 4 mit einer Photolackmaske 5 strukturiert, so daß die späteren n-Wannenbereiche (11) mit dieser Schicht 4 bei der Bor-Ionen-Implantation 6 zur Erzeugung der p-Wanne 9 bedeckt bleiben. Die Implantationsbedingungen sind die gleichen wie bei Figur 1 bereits beschrieben.

Figur 7: Nun wird unter Verwendung der Photolackmaske 5 als Ätzmaske der gleiche Unterätzschritt wie bei Figur 2 beschrieben durchgeführt und gezielt ein laterales Einätzen (siehe Pfeil 7) in die Siliziumnitridschicht 4 erzeugt.

Figur 8: Wie bei Figur 3 beschrieben, wird die Photolackmaske 5 entfernt und das Maskieroxid 8 für den p-Wannenbereich 9 für die nachfolgende Phosphor-Ionen-Implantation (10) zur Erzeugung der n-Wanne (11) erzeugt. Hierbei wird die Polysiliziumschicht 16 in ihrer vollen Schichtdicke aufoxidiert und es entsteht das Maskieroxid 8 in einer Schichtdicke von 650 nm mit einem kastenförmigen Kantenverlauf 18 im Bereich der Unterätzung 7.

Figur 9: Die Siliziumnitridstruktur 4 wird entfernt, ebenso die (nicht oxidierte) Polysiliziumschicht 16 unter der Siliziumnitridschichtstruktur 4. Die anschließende Temperung und drive-in der p-Wanne 9 erfolgt bei 1150°C in 100 bis 600 Minuten. Die Erzeugung der n-Wanne durch Phosphor-Ionen-Implantation 10 erfolgt wie bei Figur 4 beschrieben.

Figur 10: Die Verfahrensschritte sind analog denen, wie sie bei Figur 5 beschrieben sind. Desgleichen auch die nachfolgenden, aus dem Stand der Technik bekannten Prozeßschritte zur Fertigstellung des Bauelementes. Wie aus Figur 10 zu entnehmen ist, wird durch das Unterätzen (7) in die Nitridmaske (4) und das anschließende Aufoxidieren der freigelegten Polysiliziumschicht (16) zu einem kastenförmigen Maskieroxid (8, 18) eine steilere Diffusionsfront bei der n-Wanneneintreibung (11) erreicht.

Die in Figur 1 bis 10 beschriebenen Prozeßabläufe gelten für einen p-Wannen-Prozeß, der auf n-Silizium-Grundmaterial aufbaut; sinngemäß sind sie auch auf einen n-Wannen-Prozeß basierend auf p-Silizium-Grundmaterial übertragbar.

## Ansprüche

1. Verfahren zur Herstellung benachbarter, mit Dotierstoffionen unterschiedlichen Leitungstyps implantierter Wannen (9, 11) bei der Herstellung von hochintegrierten komplementären MOS-Feldeffekttransistoren (CMOS-Schaltungen), bei dem als Halbleitersubstrat (1) $n^+$-bzw. $p^+$-dotiertes Silizium mit einer darauf befindlichen $n^-$-bzw. $p^-$-dotierten Epitaxieschicht (2) verwendet wird, in die zuerst die p-Wannen (9) unter Verwendung einer mit Photolack (5) bedeckten Siliziumoxid-Siliziumnitrid-Schicht (3, 4) als Maskierungsschicht für die n-Wannenbereiche (11) und dann die n-Wannen (11) unter Verwendung einer mit Photolack bedeckten Siliziumoxidschicht (8) als Maskierungsschicht für die p-Wannenbereiche (9) eingebracht werden und bei dem durch gezieltes laterales Unterätzen (7) der für die Erzeugung der p-Wannen (9) dienenden Maskierschicht (3, 4) und nachfolgender Oxidation vor dem Erzeugen der n-Wannen (11) die Kante der als Maskierung dienenden Siliziumoxidschicht (3, 4) in Richtung n-Wannenbereich (11) verschoben wird, **dadurch gekennzeichnet,** daß die Unterätzung (7) mittels eines isotropen Ätzprozesses so geführt wird, daß sie in die unter der Photolackmaske (5) liegende Siliziumnitridmaskenschicht (4) erfolgt und dabei die darunterliegenden Schichten (1, 2, 3) nicht merklich angeätzt werden.

2. Verfahren nach Anspruch 1, **dadurch gekennzeichnet,** daß anstelle der Siliziumoxid-Siliziumnitrid-Doppelmaskenschicht (3, 4) eine Dreifachschicht, bestehend aus Siliziumoxid (3), Polysilizium (16) und Siliziumnitrid (4) verwendet wird und die Polysiliziumschicht (16) zur Maskierung der p-Wannenbereiche (9) mitaufoxidiert wird.

3. Verfahren nach Anspruch 2, **dadurch gekennzeichnet,** daß die Schichtdicke der Polysiliziumschicht (16) auf einen Bereich von 100 - 200 nm eingestellt wird.

4. Verfahren nach einem der Ansprüche 1 bis 3, **dadurch gekennzeichnet,** daß die Unterätzung Δ (7) in die Siliziumnitridmaskenschicht (4) mit 160°C heißer Phosphorsäure ($H_3PO_4$) von 85 % durchgeführt wird.

5. Verfahren nach einem der Ansprüche 1 bis 4, **dadurch gekennzeichnet,** daß zum Schutz der Siliziumnitridoberfläche beim Unterätzen der Siliziumnitridmaskenschicht (4) zwischen Siliziumnitridschicht (4) und dem Photolack (5) eine Polysiliziumhilfsschicht abgeschieden wird, die mit der Photolackmaske (5) strukturiert wird.

**FIG 1**

**FIG 2**

**FIG 3**

FIG 4

FIG 5

FIG 6

**FIG 7**

**FIG 8**

**FIG 9**

**FIG 10**